# EUROPÄISCHE PATENTSCHRIFT

(11) **EP 3 526 809 B1**
(45) Veröffentlichungstag und Bekanntmachung des Hinweises auf die Patenterteilung: **05.08.2020**
(21) Anmeldenummer: 17786859.3
(22) Anmeldetag: 05.10.2017
(51) Int. Cl.: H01H 85/47, H01H 85/00

(54) **SCHALTUNGSANORDNUNG MIT EINER SCHMELZSICHERUNG, KRAFTFAHRZEUG UND VERFAHREN ZUM HERSTELLEN DER SCHALTUNGSANORDNUNG**
CIRCUIT ARRANGEMENT COMPRISING A FUSE, MOTOR VEHICLE, AND METHOD FOR MANUFACTURING SAID CIRCUIT ARRANGEMENT
CIRCUIT DOTÉ D'UN COUPE-CIRCUIT FUSIBLE, VÉHICULE À MOTEUR ET PROCÉDÉ DE PRODUCTION DUDIT CIRCUIT

(30) Priorität: 14.10.2016 DE 102016220058
(43) Veröffentlichungstag der Anmeldung: 21.08.2019
(73) Patentinhaber: Vitesco Technologies GmbH, 30165 Hannover (DE)
(72) Erfinder: JASTER, Magnus, 14774 Kirchmöser (DE)
(74) Vertreter: Waldmann, Georg Alexander
(86) Internationale Anmeldenummer: PCT/EP2017/075343
(87) Internationale Veröffentlichungsnummer: WO 2018/069141

(56) Entgegenhaltungen:
- DE-U1-202009 017 813
- DE-U1-202015 101 661
- GB-A- 1 221 387
- GB-A- 2 026 247
- US-A- 3 793 603
- US-A- 3 810 063
- US-A1- 2014 266 565

## Beschreibung

Die Erfindung betrifft eine Schaltungsanordnung mit einer Schmelzsicherung, die zwischen zwei Anschlussbereichen der Schaltungsanordnung bereitgestellt ist. Zu der Erfindung gehören auch ein Kraftfahrzeug, bei welchem eine Spannungsquelle und ein Hochstromverbraucher über die erfindungsgemäße Schaltungsanordnung verbunden sind, sowie ein Verfahren zum Herstellen der Schaltungsanordnung.

In einem Kraftfahrzeug kann es nötig sein, in dessen elektrischer Anlage eine Hochstromsicherung bereitzustellen, die einen Dauerstrom ohne Auslösen tragen kann und dennoch ein flinkes Ansprechverhalten bei Überschreiten einer Höchststromschwelle aufweist. Dafür qualifizierte Sicherungen sind in der Regel verhältnismäßig groß und stellen daher eine punktuelle Masse dar, die bei Vibrationen zu schwingen anfängt und hierdurch z.B. in einem Kraftfahrzeug beispielsweise Lötverbindungen brechen lassen kann.

Aus DE 20 2015 101661 U1 ist eine Leiterplatine mit einer Anzahl von Leiterbahnen bekannt, die auf einer Oberseite eines Trägers aufgebracht sind. Dabei weist eine Leiterbahn zur Ausbildung eines Schmelzsicherungselements in einem Abschnitt eine Querschnittsverringerung auf. Auf einer der Oberseite gegenüberliegenden Unterseite des Trägers ist eine Materialaussparung ausgebildet, welche im Bereich des Abschnitts mit der Querschnittsverjüngung positioniert ist.

Aus DE 20 2009 017813 U1 ist eine Überstromsicherung für verschieden hohe Ströme zum Einsatz in elektrischen Schaltkreisen bekannt, die aus einem Basismaterial, einem Schmelzmaterial, einem Hohlraum und Kontakten besteht.

Aus US 2014/266565 A1 ist eine kompakte Schmelzsicherung mit einem hohen Schaltvermögen bekannt, die eine obere Isolierschicht, eine dazwischenliegende Isolierschicht und eine untere Isolierschicht enthält, wobei die Schichten in einer vertikal gestapelten Konfiguration angeordnet sind.

Aus US 3 793 603 A ist eine elektrische Sicherung mit einem hohlen Isolierkörper bekannt, der ein schmelzbares Element oder schmelzbare Elemente umschließt und Anschlüsse der Sicherung trägt.

Aus GB 1 221 387 A ist eine Schmelzsicherung bekannt, deren Isolierkörper außerhalb der Sicherungskontakte an einem Kühlkörper anliegt. Dabei trägt eine große Oberfläche des quaderförmig ausgebildeten Isolierkörpers einer hohen Wärmeleitung bei.

Aus US 3 810 063 A ist eine strombegrenzende Sicherungsstruktur bekannt, die eine Vielzahl von Elementen aus schmelzbarem Material umfasst, die für den Betrieb eines Schaltkreises mit höherer Spannung ausgelegt sind. Jedes Sicherungselement hat eine Vielzahl von Bereichen mit verringertem Querschnitt, um die Erzeugung einer Vielzahl von Lichtbögen zum Zeitpunkt des Schmelzens zu erleichtern, um den elektrischen Strom in dem zu schützenden Stromkreis während des Durchbrennens der Sicherung zu begrenzen.

Aus GB 2 026 247 A ist eine Strombegrenzungsvorrichtung bekannt, die einen selbstrückstellenden Strombegrenzer mit einem bei Oberstrom seine Phase ändernden Strombegrenzungsmaterial, mit Stromanschlüssen an seinen beiden Enden und mit Kühlrippen aufweisenden Kühlkörpern an seinen beiden Stromanschlüssen aufweist.

Der Erfindung liegt die Aufgabe zugrunde, eine Schaltungsanordnung mit Schmelzsicherung für eine vibrierende Anwendungsumgebung bereitzustellen.

Die Aufgabe wird durch die Gegenstände der unabhängigen Patentansprüche gelöst. Vorteilhafte Weiterbildungen der Erfindung sind durch die abhängigen Patentansprüche, die folgende Beschreibung sowie die Figuren beschrieben.

Die erfindungsgemäße Schaltungsanordnung stellt zwischen zwei Anschlussbereichen eine elektrische Verbindung mit Schmelzsicherung bereit. Die Schmelzsicherung ist hierbei als Schichtanordnung ausgestaltet, also als flächig verteiltes Bauelement, das hierdurch eine über die Schichtanordnung verteilte Masse aufweist, die im Vergleich zu einer punktuell konzentrierten Masse weniger zu Schwingungen bei einer Anregung durch Vibrationen neigt. Um die Schmelzsicherung zu realisieren, ist ein Kühlkörper bereitgestellt, auf dessen Oberfläche die Schichtanordnung angeordnet ist. Die Schichtanordnung umfasst hierbei eine am Kühlkörper, d.h. auf dessen Oberfläche, angeordnete, elektrisch isolierende Schicht, die hier als Isolierschicht bezeichnet ist, und eine auf dieser Isolierschicht, d.h. auf einer dem Kühlkörper abgewandten Seite der Isolierschicht, angeordnete elektrisch leitfähige Schicht, die hier als Leiterschicht bezeichnet ist. Mit elektrisch isolierend ist hier gemeint, dass eine Leitfähigkeit oder Konduktivität eines Materials der Isolierschicht kleiner als 10-4 S/m, insbesondere kleiner als 10-7 S/m ist. Mit elektrisch leitfähig ist gemeint, dass ein Material der Leiterschicht eine elektrische Leitfähigkeit oder Konduktivität aufweist, die größer als 10.000 S/m, insbesondere größer als 100.000 S/m ist.

Die auf den Kühlkörper angeordnete Schichtanordnung aus Isolierschicht und Leiterschicht stellt einen elektrischen Verbindungspfad oder Strompfad zwischen den Anschlussbereichen bereit. Um nun gezielt einen Schmelzbereich zum Bereitstellen der Schmelzsicherung auszubilden, weist die Oberfläche des Kühlkörpers zwei Löcher oder Materialaussparungen oder Löcher auf. Zwischen diesen beiden Materialaussparungen befindet sich weiterhin Material des Kühlkörpers, d.h. durch einen zwischen den Materialaussparungen angeordneten Teil des Kühlkörpers ist ein Brückenelement gebildet, welches zwischen den beiden Materialaussparungen hindurch führt und zwei Oberflächenbereiche diesseits und jenseits der Materialaussparungen verbindet. Die Schichtanordnung ist über dieses Brückenelement durchführt. Mit anderen Worten liegt ein Teil der Schichtanordnung auf dem Brückenelement auf. Insbesondere ist die Schichtanordnung zwischen den beiden Materialaussparungen so breit wie das Brückenelement selbst.

Durch die Erfindung ergibt sich der Vorteil, dass eine flächige Schichtanordnung zwischen den beiden Anschlussbereichen auf einem Kühlkörper bereitgestellt ist und diese als Schmelzsicherung fungiert. Es gibt also kein konzentriertes Bauteil als Schmelzsicherung, welches zu Eigenschwingungen neigen könnte. Der Kühlkörper kann als steifes Trägerelement genutzt werden und beispielsweise aus Metall, insbesondere Aluminium oder einer Aluminiumlegierung, gebildet sein. Dies versteift die Schichtanordnung und gewährleistet eine thermische Leitfähigkeit. Bei einem Stromfluss durch die Leiterschicht kann eine darin umgesetzte Verlustwärme flächig in den Kühlkörper übertragen werden. Im Bereich des Brückenelements ergibt sich allerdings durch die Materialaussparungen ein Wärmestau oder eine Wärmekonzentration, sodass die Wärme sich vom Brückenelement aus nicht in alle Richtungen über das Material des Kühlkörpers ausbreiten kann. Durch Einstellen der Breite des Brückenelements, der Leiterschichtdicke und des Leitermaterials lässt sich ein Schmelzpunkt festlegen, d.h. eine Stromstärke, bei welcher die Leiterschicht schmilzt, einstellen.

Die Schichtanordnung wird bevorzugt durch ein erfindungsgemäßes Verfahren hergestellt, mittels welchem das Material der Isolierschicht und der Leiterschicht auf dem Kühlkörper mittels Kaltgasspritzen (CGDM - Cold Gas Dynamic Method) auf der Oberfläche des Kühlkörpers schichtweise aufgetragen wird. Hierdurch wird ein Granulat oder Pulver, welches das jeweilige Material der Isolierschicht und der Leiterschicht darstellt, auf dem Kühlkörper verzahnt und/oder angeschmolzen. Das erfindungsgemäße Verfahren sieht somit vor, dass auf der Oberfläche des Kühlkörpers mittels Kaltgasspritzen die Schichtanordnung aus der am Kühlkörper angeordneten Isolierschicht mittels eines elektrisch isolierenden Materials, zum Beispiel einer Keramik oder Aluminiumoxid, und einer auf dieser Isolierschicht an der dem Kühlkörper abgewandten Seite angeordneten Leiterschicht aus einem elektrisch leitfähigen Material, zum Beispiel Kupfer, Aluminium oder einer Aluminiumlegierung, erzeugt wird. Eine Form der Isolierschicht und/oder der Leiterschicht kann beispielsweise mittels einer Schablone oder Maske beim Spritzen festgelegt werden. Hierdurch lässt sich die Schichtanordnung in der Weise formen, dass der beschriebene elektrische Verbindungspfad zwischen den beiden Anschlussbereichen bereitgestellt wird. Zum Bereitstellen der Schmelzsicherung wird die Oberfläche des Kühlkörpers nicht einfach glatt oder eben bereitgestellt, sondern mit zwei Materialaussparungen versehen, zum Beispiel Durchgangslöchern oder Sacklöchern. Hierdurch bildet der zwischen den Materialaussparungen angeordneter Teil des Körpers das Brückenelement, auf welchem die besagte Schichtanordnung ganz oder teilweise mittels des Kaltgasspritzens erzeugt oder aufgetragen oder angeordnet wird.

Bei der Schichtanordnung handelt sich also nicht um eine Mikrostruktur eines integrierten Schaltkreises auf einem Substrat. Die Leiterschicht ist insbesondere mindestens 1 mm breit und/oder der Verbindungspfad mindestens 1 cm lang.

Zu der Erfindung gehören auch optionale Weiterbildungen, durch deren Merkmale sich zusätzliche Vorteile ergeben.

Um einen Lichtbogen löschen zu können, der sich beim Aufschmelzen der Leiterschicht ergeben kann, ist vorgesehen, dass die Schichtanordnung ein an der Leiterschicht angeordnetes, d.h. diese bedeckendes, umhüllendes oder beschichtendes elektrisch isolierendes Schmelzmaterial aufweist, d.h. eine Schmelzschicht. Das Schmelzmaterial weist einen Schmelzpunkt in einem Bereich über 400°C auf und weist durch das Kaltgasspritzen eine Porösität auf. Eine solche Schmelzschicht kann beispielsweise auf der Grundlage eines Quarz-Materials (zum Beispiel Silizium-Oxid) oder einer Keramik als Schmelzmaterial und/oder als Kondensator für eine Kondensation eines Dampfs von dem Leitermaterial der Leiterschicht bereitgestellt werden.

Um einen Lichtbogen einzuschließen oder einzukapseln und um mit kleineren Kriechstrecken für elektrische Kriech-ströme auszukommen, ist bevorzugt vorgesehen, dass die Leiterschicht entlang des Verlaufs des Verbindungspfads vollständig mit einem isolierenden Material eingehüllt ist. Mit anderen Worten ist bevorzugt ein Isolierschlauch um die Leiterschicht gelegt. Um dies mittels der Schichtanordnung zu erreichen, weist die Schichtanordnung bevorzugt eine Hüllschicht aus einem elektrisch isolierenden Material auf, d.h. die Schichtanordnung ist zu einer Umgebung hin mit der Hüllschicht abgegrenzt. Die Hüllschicht liegt also auf der Leiterschicht oder der Schmelzschicht auf. Die Hüllschicht ist dabei entlang des Verlaufs des elektrischen Verbindungspfads beiderseits, d.h. rechts und links der Verlaufsachse oder Längsachse des Verbindungspfads, mit der (unteren) Isolierschicht verbunden, die sich zwischen der Leiterschicht und der Oberfläche des Kühlkörpers befindet. Hierdurch ist also die Leiterschicht vollständig von dem elektrisch isolierenden Material umgeben.

Um den besagten Hitzestau im Bereich des Brückenelements zu gewährleisten, sind die Materialaussparungen bevorzugt mit einem thermisch isolierenden Material gefüllt. Insbesondere ist bevorzugt vorgesehen, dass die Materialaussparungen mit Luft gefüllt sind.

Um die Auslösestromstärke der Schmelzsicherung auf einen vorgebbaren Schwellenwert einzustellen, ist die Wärmekapazität im Bereich des Brückenelements festzulegen oder einzustellen. Hierzu kann vorgesehen sein, dass das Brückenelement eine Dicke aufweist, die kleiner als die Dicke des restlichen Kühlkörpers, d.h. in dem an das Brückenelement angrenzenden Bereich ist. Mit Dicke ist hierbei die Abmessung senkrecht zur Oberfläche des Kühlkörpers gemeint. Mit anderen Worten kann das Brückenelement also beispielsweise von einer Rückseite des Kühlkörpers her (der Oberfläche gegenüber angeordnet) ausgehöhlt oder mit einer Aussparung versehen sein.

Um eine Kühlwirkung des Kühlkörpers im Bereich außerhalb des Brückenelements zu verbessern und hier die Leiterschicht auch bei einer Stromstärke größer als 10 A, insbesondere größer als 50 A, unter einem vorgegebenen Temperaturwert zu halten, ist bevorzugt vorgesehen, dass der Kühlkörper zumindest einen Kühlkanal zum Führen eines Kühlmediums aufweist. Mit anderen Worten kann der Kühlkörper zum Beispiel zumindest eine Durchgangsöffnung oder ein Loch aufweisen. Der Temperaturwert kann so beispielsweise im Bereich von 50° bis 400° liegen.

Um dennoch eine Hitzeansammlung oder einen Hitzestau im Bereich des Brückenelements innerhalb der Leiterschicht zu gewährleisten, ist bevorzugt vorgesehen, dass ein Material der Leiterschicht zumindest im Bereich des Brückenelements porös ist. Hierdurch ist zwischen dem elektrisch leitfähigen Material der Leiterschicht Luft vorhanden, die einen Wärmeübertritt oder eine Wärmeausbreitung im Vergleich zu einer massiv aus dem elektrisch leitfähigen Material gebildeten Leiterschicht verringert.

Der Kühlkörper muss nicht ausschließlich für die Leiterschicht bereitgestellt sein. Bevorzugt trägt der Kühlkörper zusätzlich zumindest ein elektronisches Bauelement, d.h. es kann insgesamt eine elektrische Schaltung auf dem Kühlkörper angeordnet und gekühlt sein. Somit ist auf einer Oberfläche des Kühlkörpers zumindest ein schaltbares elektronisches Bauelement, zum Beispiel ein Transistor, angeordnet, wobei das Bauelement dann mit einem der besagten Anschlussbereiche elektrisch verschaltet ist.

Das bereits erwähnte erfindungsgemäße Kraftfahrzeug zeichnet sich durch die erfindungsgemäße Schaltungsanordnung aus. Bei dem erfindungsgemäßen Kraftfahrzeug ist bevorzugt eine elektrische Spannungsquelle, zum Beispiel eine Batterie und/oder ein Generator, mit zumindest einem Hochstromverbraucher verbunden. Als Hochstromverbraucher wird hier ein elektrischer Verbraucher bezeichnet, der einen Betriebsstrom größer als 10 A aufweisen kann. Ein Hochstromverbraucher kann beispielsweise durch ein elektrisches PTC-Heizelement (PTC - Positive Temperature Coefficient) oder eine elektrische Maschine gebildet sein. Die Spannungsquelle und der zumindest eine Hochstromverbraucher sind über eine Ausführungsform der erfindungsgemäßen Schaltungsanordnung elektrisch verbunden. Hierdurch führt also der beschriebene elektrische Verbindungspfad als Hochstrompfad von der Spannungsquelle hin zu dem zumindest einen elektrischen Verbraucher oder andersherum vom zumindest einen elektrischen Hochstromverbraucher hin zur Spannungsquelle.

Zu der Erfindung gehören auch Weiterbildungen des erfindungsgemäßen Verfahrens, die Merkmale aufweisen, wie sie bereits im Zusammenhang mit den Weiterbildungen der erfindungsgemäßen Schaltungsanordnung beschrieben worden sind. Aus diesem Grund sind die entsprechenden Weiterbildungen des erfindungsgemäßen Verfahrens hier nicht noch einmal beschrieben.

Im Folgenden ist ein Ausführungsbeispiel der Erfindung beschrieben. Hierzu zeigt:
Fig. 1 eine schematische Darstellung einer Ausführungsform des erfindungsgemäßen Kraftfahrzeugs;
Fig. 2 eine schematische Darstellung einer perspektivischen Ansicht einer Schaltungsanordnung des Kraftfahrzeugs von Fig. 1;
Fig. 3 eine schematische Darstellung eines Querschnitts der Schaltungsanordnung von Fig. 2; und
Fig. 4 eine schematische Darstellung einer Seitenansicht des Brückenelements der Schaltungsanordnung von Fig. 2.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

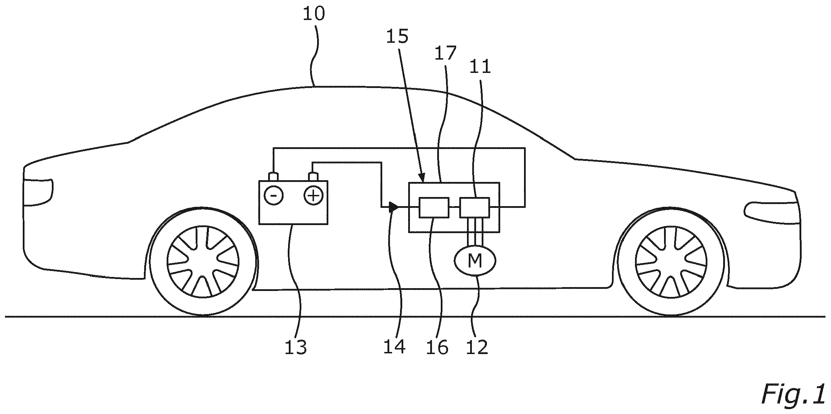

Fig. 1 zeigt ein Kraftfahrzeug 10, bei dem es sich beispielsweise um einen Kraftwagen, insbesondere einen Personenkraftwagen oder Lastkraftwagen, handeln kann. Das Kraftfahrzeug 10 kann einen Hochstromverbraucher 11 aufweisen, der in dem gezeigten Beispiel ein Inverter oder Wechselrichter einer elektrischen Maschine 12 sein kann. Mittels der elektrischen Maschine 12 kann beispielsweise ein Fahrantrieb für das Kraftfahrzeug 10 bereitgestellt sein. Zum Betreiben oder Versorgen des Hochstromverbrauchers 11 kann dieser mit einer Spannungsquelle 13 elektrisch verbunden sein, bei der es sich in dem gezeigten Beispiel um eine Batterie, beispielsweise eine Traktionsbatterie oder Hochvoltbatterie handeln kann. Der Hochstromverbraucher 11 kann auch beispielsweise eine Heizanwendung sein. Ein Betriebsstrom 14 für den Hochstromverbraucher 11 kann größer als 10 A, insbesondere größer als 50 A, sein.

Zum Absichern gegen einen Kurzschluss oder einen anderen Fehler ist eine Schaltungsanordnung 15 bereitgestellt, durch welche eine Schmelzsicherung 16 zum Unterbrechen des Betriebsstromes 14 für den Fall bereitgestellt sein kann, dass eine Stromstärke des Betriebsstroms 14 größer als ein vorbestimmter Schwellenwert ist. Die Schaltungsanordnung 15 kann einen Kühlkörper 17 aufweisen, auf welchem gemeinsam die Schmelzsicherung 16 und der Hochstromverbraucher 11 angeordnet sein können, d.h. elektronische Bauelemente des Hochstromverbrauchers 11 können in die Schaltungsanordnung 15 integriert sein. Die Schmelzsicherung 16 ist flach oder flächig verteilt und zusätzlich durch den Kühlkörper 17 versteift. Bei Vibrationen während einer Fahrt des Kraftfahrzeugs 10 kann somit die Schmelzsicherung durch die Vibrationen nicht zu einer Eigenschwingung angeregt oder aufgeschaukelt werden.

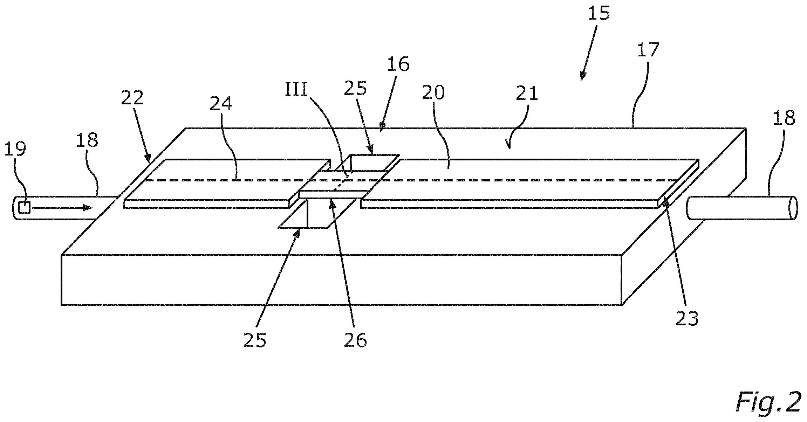

Fig. 2 veranschaulicht die flächige oder flache Ausgestaltung der Schmelzsicherung 16. Zudem ist eine gleichmäßige Kühlung, d.h. eine Vermeidung von Hitzestaus (Hotspots), gewährleistet.

Fig. 2 zeigt den Kühlkörper 17, der beispielsweise ein Spritzgussbauteil sein kann. Ein Material des Kühlkörpers 17 kann beispielsweise Aluminium oder eine Aluminiumlegierung umfassen.

Mittels eines Kühlkanals 18 kann ein Kühlmedium 19 zum Abtransportieren oder Ableiten von Wärmeenergie aus dem Kühlkörper 17 durch diesen hindurch oder daran vorbei geleitet oder geführt oder geströmt werden.

Die Schmelzsicherung 16 ist durch eine Schichtanordnung 20 gebildet, die auf einer Oberfläche 21 des Kühlkörpers 17 angeordnet sein kann. Die Schichtanordnung 20 weist einen elektrisch leitfähigen Teil auf, sodass ein erster Anschlussbereich 22 und ein zweiter Anschlussbereich 23 über die Schichtanordnung 20 elektrisch verbunden sind und sich hierdurch für den Betriebsstroms 14 ein elektrischer Verbindungspfad 24 zwischen den Anschlussbereichen 22, 23 ergibt.

Entlang dieses Verbindungspfads 24 ist durch die Schichtanordnung 20 und den Kühlkörper 17 die Schmelzsicherung 16 bereitgestellt. Der Kühlkörper 17 weist hierzu an seiner Oberfläche 21 zwei Materialaussparungen 25 auf, die beispielsweise beim Herstellen des Kühlkörpers 17 durch eine entsprechende Gussform und/oder durch Ausfräsen oder Ausbohren hergestellt sein können. Durch den verbleibenden Teil des Kühlkörpers 17 zwischen den Materialaussparungen 25 ist ein Brückenelement 26 gebildet, auf welchem ein Teil der Schichtanordnung 20 angeordnet sein kann. Die Schichtanordnung 20 kann im Bereich des Brückenelements 26 auch schmaler als diesseits und jenseits des Brückenelements entlang des Verlaufs des elektrischen Verbindungspfads 24 ausgestaltet sein, wie dies in Fig. 2 veranschaulicht ist.

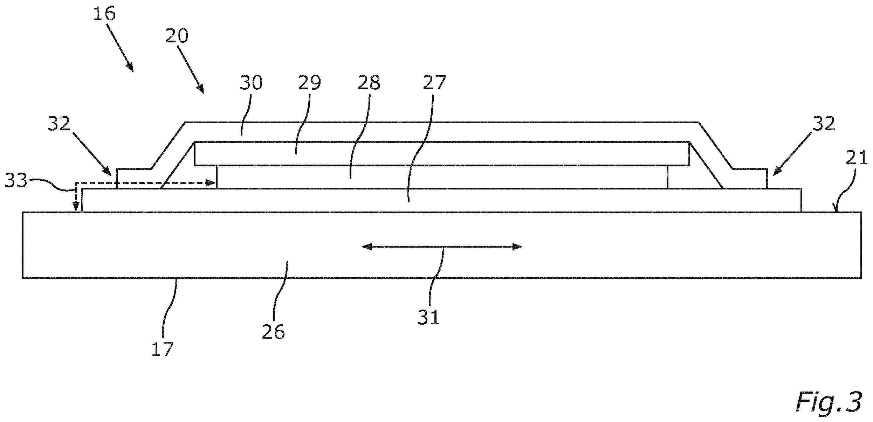

Fig. 3 veranschaulicht einen Querschnitt senkrecht zum Verlauf des Verbindungspfads 24. Die Schnittlinie für den Schnitt gemäß Fig. 3 ist in Fig. 2 als III bezeichnet.

Ausgehend von dem Kühlkörper 17 ist auf dessen Oberfläche 21 in dem veranschaulichten Beispiel eine Isolierschicht 27, eine Leiterschicht 28, eine Schmelzschicht 29 und eine Hüllschicht 30 angeordnet. Die Schichten 27, 28, 29, 30 stellen zusammen die Schichtanordnung 20 dar. Eine weitere Schmelzschicht kann auch zwischen der Isolierschicht 27 und der Leiterschicht 28 angeordnet sein, um die Leiterschicht komplett einzuhüllen.

Die Schichtanordnung 20 für die Schmelzsicherung 16 kann in einem Beschichtungsverfahren auf die Oberfläche 21 des Kühlkörpers 17 aufgebracht werden. Insbesondere eignet sich ein Kaltgasspritzen. Auf den Kühlkörper wird hierzu die elektrisch isolierende Isolierschicht 27 aufgetragen, die bevorzugt eine Schmelztemperatur größer als 700° C, insbesondere größer als 1000° C hat. Als Material für die Isolierschicht 27 kann beispielsweise Aluminiumoxid verwendet werden. In dem Kühlkörper 17 sind die Materialaussparungen 25 vorgesehen, die die thermische Anbindung an den restlichen Teil des Kühlkörpers 17 gezielt im Bereich des Brückenelements 26 senkt. Auf dem Brückenelement wird die elektrisch leitende oder leitfähige Leitschicht 28 aufgebracht, die die Isolierschicht 27 in einer Querrichtung 31 quer zum Verbindungspfad 24 nicht vollständig, d.h. nur teilweise überdeckt und hierbei bevorzugt eine Schmelztemperatur in einem Bereich größer als 350° C, insbesondere 400° C und kleiner als 600° C insbesondere 500° C aufweist. Als Material kann beispielsweise Aluminium oder Kupfer oder eine Aluminiumlegierung vorgesehen sein. Auf der Leiterschicht 28 wird die Schmelzschicht 29 aus einem elektrisch isolierenden Material, das bei Temperaturen bevorzugt über 450°, insbesondere 500° und kleiner als 1000° C schmilzt, aufgebracht. Es kann sich beispielsweise um Quarz, Siliziumoxid oder eine Keramik handeln.

Die Schmelzschicht 27 überdeckt die Leiterschicht 28 entlang der Querrichtung 31 vollständig und kann auch breiter als die Leiterschicht 28 sein, diese also entlang der Querrichtung 31 überragen. Die Schmelzschicht 29 bleibt oder ist aber schmaler in Querrichtung 31 als die Isolierschicht 27. Abschließend wird die Hüllschicht 30 als schützende elektrisch isolierende Außenschicht aufgetragen. Ein Material der Hüllschicht 30 kann dasselbe sein wie das Material der Isolierschicht 27. Indem die Hüllschicht 30 breiter ist als die Schmelzschicht 29 und die Leiterschicht 28 ergibt sich eine Materialverbindung 32 zwischen der Hüllschicht 30 und der Isolierschicht 27, wodurch die Leiterschicht 28 und die Schmelzschicht 29 vollständig von dem elektrisch isolierenden Material eingeschlossen oder umgeben sind. Hierdurch kann eine Kriechstrecke 33 zwischen dem elektrisch leitfähigen Material der Leiterschicht 28 und des Kühlkörpers 17 besonders kurz ausgestaltet sein, da eine elektrische Verbindung über Luft unterbunden ist.

Durch die eingeschränkte thermische Kopplung aufgrund der Hohlräume der Materialaussparungen 25 an den Kühlkörper 17 und die thermische Masse des Brückenelements 26 werden Dauerströme in Form des Betriebsstroms 14 und kurzzeitige Spitzenströme bis zu einer vorgegebenen maximalen Stromstärke pro Zeit die Leiterschicht 28 bei einer Temperatur kleiner als die Schmelztemperatur im Bereich des Brückenelements 26 halten. Steigt die Stromstärke des Betriebsstroms 14 jedoch auf einen definierten höheren Stromstärkewert an, so erwärmt sich die Leiterschicht 28 im Bereich des Brückenelements 26 derart stark, dass die Leiterschicht 28 schmilzt und ein Lichtbogen an der elektrisch unterbrochenen Stelle entstehen kann, der dann auch das Material der Schmelzschicht 29 schmelzt und/oder der verdampfte Leiter sich in dem restlichen Teil der porösen Schmelzschicht als Kondensat ablagert was wiederum dazu führt, dass der Lichtbogen wieder gelöscht wird und die Verbindung hochohmig bleibt. Durch die umgebende Hochtemperaturhülle in Form des elektrisch isolierenden Materials der Hüllschicht 30 und der Isolierschicht 27 wird dieser Vorgang nach außen hin abgeschlossen.

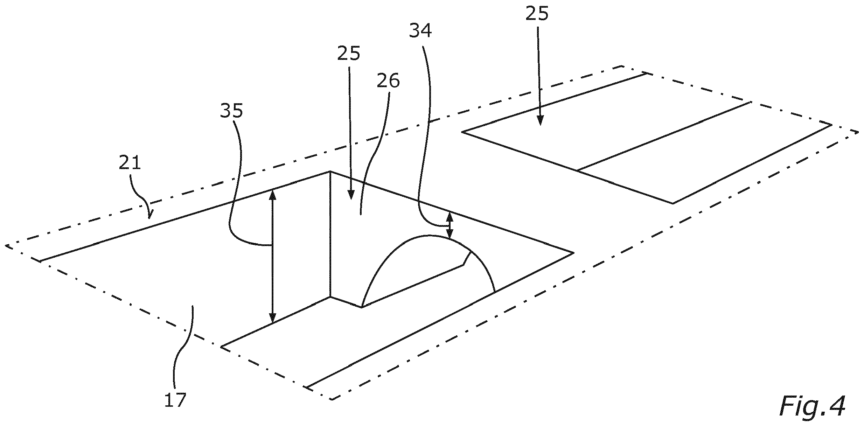

Um die thermische Leitfähigkeit des Brückenelements 26 gezielt einzustellen, kann die in Fig. 4 gezeigte Veränderung der Dicke 34 des Brückenelements 26 vorgesehen sein. Die Dicke 34 kann geringer sein als eine Dicke 35 des restlichen Kühlkörpers 17.

Durch die Möglichkeit einer durchgängigen Kühlung der Leiterschicht 28 ergibt sich eine Reduktion eines Alterungseffekts durch Spitzenströme in der Schichtanordnung 20. Bei gegebener Stromtragfähigkeit kann die Schmelzsicherung 16 kompakter ausgestaltet werden als ein konzentriertes Bauelement. Durch die beschriebenen Maßnahmen ist die Schmelzsicherung 16 auch gut skalierbar und integrierbar in Anwendungen, wie im Zusammenhang mit Fig. 1 durch die Kombination der Schaltungsanordnung 15 aus einem einzelnen Kühlkörper 17 und der Schmelzsicherung zusammen mit dem Hochstromverbraucher 11 beispielhaft veranschaulicht.

Die Integration in einen gekühlten Hochstrompfad durch Aufbringen auf die Oberfläche 21 eines Kühlkörpers 17 ist vorteilhaft, weil keine konzentrierte Masse, wie bei einer herkömmlichen Schmelzsicherung, durch Vibrationen starke Kräfte an den elektrischen Verbindungsstellen hervorruft, sondern die Sicherung Teil des Strompfades ist, der als Ganzes integriert wird.

Insgesamt zeigt das Beispiel, wie durch die Erfindung eine geschichtete Schmelzsicherung bereitgestellt werden kann.

## Patentansprüche

1. Schaltungsanordnung (15) mit einer Schmelzsicherung (16), die zwei Anschlussbereiche (22, 23) elektrisch verbindet, aufweisend:
- einen Kühlkörper (17) und
- eine auf einer Oberfläche (21) des Kühlkörpers (17) angeordnete Schichtanordnung (20), die eine am Kühlkörper (17) angeordnete, elektrisch isolierende Isolierschicht (27) und eine auf einer dem Kühlkörper (17) abgewandten Seite der Isolierschicht (27) angeordnete elektrisch leitfähige Leiterschicht (28) aufweist, wobei durch die Schichtanordnung (20) ein elektrischer Verbindungspfad (24) zwischen den Anschlussbereichen (22, 23) bereitgestellt ist,
**dadurch gekennzeichnet , dass** zum Bereitstellen der Schmelzsicherung (16) die Oberfläche (21) des Kühlkörpers (17) zwei Materialaussparungen (25) aufweist und durch einen zwischen den Materialaussparungen (25) angeordneten Teil des Kühlkörpers (17) ein Brückenelement (26) gebildet ist und die Schichtanordnung (20) über das Brückenelement (26) geführt ist.

2. Schaltungsanordnung (15) nach Anspruch 1, wobei die Schichtanordnung (20) zumindest eine an der Leiterschicht (28) angeordnete Schmelzschicht (29) aus einem elektrisch isolierenden Schmelzmaterial aufweist, welches einen Schmelzpunkt in einem Bereich größer als 400°C aufweist.

3. Schaltungsanordnung (15) nach Anspruch 2, wobei die zumindest eine Schmelzschicht porös ist.

4. Schaltungsanordnung (15) nach einem der vorhergehenden Ansprüche, wobei die Schichtanordnung (20) eine die Schichtanordnung (20) zu einer Umgebung hin abgrenzende Hüllschicht (30) aus einem elektrisch isolierenden Material aufweist, wobei die Hüllschicht (30) entlang eines Verlaufes des elektrischen Verbindungspfads (24) beiderseits des Verbindungspfads (24) mit der Isolierschicht (27) verbunden (32) ist.

5. Schaltungsanordnung (15) nach einem der vorhergehenden Ansprüche, wobei die Materialaussparungen (25) mit Luft gefüllt sind.

6. Schaltungsanordnung (15) nach einem der vorhergehenden Ansprüche, wobei das Brückenelement (26) eine senkrecht zur Oberfläche (21) gemessene Dicke (34) aufweist, die kleiner als eine Dicke (35) des Kühlkörpers (17) in einem an das Brückenelement (26) angrenzenden Bereich ist.

7. Schaltungsanordnung (15) nach einem der vorhergehenden Ansprüche, wobei in oder an dem Kühlkörper (17) zumindest ein Kühlkanal (18) zum Führen eines Kühlmediums (19) bereitgestellt ist.

8. Schaltungsanordnung (15) nach einem der vorhergehenden Ansprüche, wobei ein Material der Leiterschicht (28) zumindest im Bereich des Brückenelements (26) porös ist.

9. Schaltungsanordnung (15) nach einem der vorhergehenden Ansprüche, wobei auf der Oberfläche (21) des Kühlkörpers (17) zumindest ein schaltbares elektronisches Bauelement (11) angeordnet ist, welches mit einem der Anschlussbereiche (22, 23) elektrisch verschaltet ist.

10. Kraftfahrzeug (10) mit einer elektrischen Spannungsquelle (13) und mit zumindest einem Hochstromverbraucher (11), welcher einen Betriebsstrom (14) größer als 10 A aufweist, **dadurch gekennzeichnet, dass** die Spannungsquelle (13) und der zumindest eine Hochstromverbraucher (11) über eine Schaltungsanordnung (15) nach einem der vorhergehenden Ansprüche elektrisch verbunden sind.

11. Verfahren zum Herstellen einer Schaltungsanordnung (15) mit einer Schmelzsicherung (16), wobei auf einer Oberfläche (21) eines Kühlkörpers (17) mittels Kaltgasspritzen eine Schichtanordnung (20) aus einer am Kühlkörper (17) angeordneten Isolierschicht (27) aus einem elektrisch isolierenden Material und eine auf einer dem Kühlkörper (17) abgewandten Seite der Isolierschicht (27) angeordneten Leiterschicht (28) aus einem elektrisch leitfähigen Material erzeugt wird, wobei durch die Schichtanordnung (20) ein elektrischer Verbindungspfad (24) zwischen zwei Anschlussbereichen (22, 23) bereitgestellt wird, **dadurch gekennzeichnet, dass** zum Bereitstellen der Schmelzsicherung (16) die Oberfläche (21) des Kühlkörpers (17) mit zwei Materialaussparungen (25) bereitgestellt wird, so dass durch einen zwischen den Materialaussparungen (25) angeordneten Teil des Kühlkörpers (17) ein Brückenelement (26) gebildet ist, und die Schichtanordnung (20) ganz oder teilweise auf dem Brückenelement (26) erzeugt wird.

## Claims

1. Circuit arrangement (15) comprising a fuse (16) which electrically connects two connection regions (22, 23), having:
- a heat sink (17) and
- a layer arrangement (20) which is arranged on a surface (21) of the heat sink (17) and has an electrically insulating insulation layer (27), which is arranged on the heat sink (17), and an electrically conductive conductor layer (28) which is arranged on a side of the insulation layer (27) that faces away from the heat sink (17), wherein an electrical connecting path (24) between the connection regions (22, 23) is provided by the layer arrangement (20),
**characterized in that**,
for providing the fuse (16), the surface (21) of the heat sink (17) has two material cutouts (25), and a bridge element (26) is formed by a portion of the heat sink (17) that is arranged between the material cutouts (25), and the layer arrangement (20) is guided over the bridge element (26).

2. Circuit arrangement (16) according to Claim 1, wherein the layer arrangement (20) has at least one melting layer (29) which is arranged on the conductor layer (28) and is composed of an electrically insulating melting material which has a melting point in a region greater than 400°C.

3. Circuit arrangement (150) according to Claim 2, wherein the at least one melting layer is porous.

4. Circuit arrangement (15) according to one of the preceding claims, wherein the layer arrangement (20) has a shell layer (30) which delimits the layer arrangement (20) with respect to a surrounding area and is composed of an electrically insulating material, wherein the shell layer (30) is connected to the insulation layer (27) along a profile of the electrical connecting path (24) on either side of the connecting path (24) .

5. Circuit arrangement (15) according to one of the preceding claims, wherein the material cutouts (25) are filled with air.

6. Circuit arrangement (15) according to one of the preceding claims, wherein the bridge element (26) has a thickness (34), measured perpendicularly to the surface (21), which is smaller than a thickness (35) of the heat sink (17) in a region adjoining the bridge element (26).

7. Circuit arrangement (15) according to one of the preceding claims, wherein at least one cooling duct (18) for guiding a cooling medium (19) is provided in or on the heat sink (17).

8. Circuit arrangement (15) according to one of the preceding claims, wherein a material of the conductor layer (28) is porous at least in the region of the bridge element (26).

9. Circuit arrangement (15) according to one of the preceding claims, wherein at least one switchable electronic component (11) which is electrically connected to one of the connection regions (22, 23) is arranged on the surface (21) of the heat sink (17).

10. Motor vehicle (10) comprising an electrical voltage source (13) and comprising at least one high-current load (11) which has an operating current (14) of greater than 10 A, **characterized in that** the voltage source (13) and the at least one high-current load (11) are electrically connected by means of a circuit arrangement (15) according to one of the preceding claims.

11. Method for manufacturing a circuit arrangement (15) comprising a fuse (16), wherein a layer arrangement (20) consisting of an insulation layer (27), which is arranged on the heat sink (17) and is composed of an electrically insulating material, and a conductor layer (28), which is arranged on a side of the insulation layer (27) that faces away from the heat sink (17) and is composed of an electrically conductive material, is produced on a surface (21) of a heat sink (17) by means of cold gas spraying, wherein an electrical connecting path (24) between two connection regions (22, 23) is provided by the layer arrangement (20), **characterized in that**, for the purpose of providing the fuse (16), the surface (21) of the heat sink (17) is provided with two material cutouts (25), so that a bridge element (26) is formed by a portion of the heat sink (17) that is arranged between the material cutouts (25), and the layer arrangement (20) is entirely or partially produced on the bridge element (26).

## Revendications

1. Arrangement de circuit (15) comprenant un fusible (16) qui relie électriquement deux zones de raccordement (22, 23), comprenant :
- un dissipateur thermique (17) et
- un arrangement de couches (20) disposé sur une surface (21) du dissipateur thermique (17), lequel possède une couche isolante (27) électriquement isolante disposée sur le dissipateur thermique (17) et une couche conductrice (28) électriquement conductrice disposée sur un côté de la couche isolante (27) à l'opposé du dissipateur thermique (17), un trajet de liaison électrique (24) étant produit entre les zones de raccordement (22, 23) par l'arrangement de couches (20),
**caractérisé en ce que**
pour produire le fusible (16), la surface (21) du dissipateur thermique (17) possède deux épargnes de matière (25) et un élément formant cavalier (26) est formé par une partie du dissipateur thermique (17) disposée entre les épargnes de matière (25) et l'arrangement de couches (20) est passé au-dessus de l'élément formant cavalier (26).

2. Arrangement de circuit (15) selon la revendication 1, l'arrangement de couches (20) possédant au moins une couche fusible (29) disposée au niveau de la couche conductrice (28) en un matériau fusible électriquement isolant, lequel présente un point de fusion dans une plage au-dessus de 400 °C.

3. Arrangement de circuit (15) selon la revendication 2, l'au moins une couche fusible étant poreuse.

4. Arrangement de circuit (15) selon l'une des revendications précédentes, l'arrangement de couches (20) possédant une couche d'enveloppe (30) en un matériau électriquement isolant qui délimite l'arrangement de couches (20) par rapport à l'environnement, la couche d'enveloppe (30) étant reliée (32) à la couche isolante (27) le long d'un tracé du trajet de liaison électrique (24) des deux côtés du trajet de liaison électrique (24) .

5. Arrangement de circuit (15) selon l'une des revendications précédentes, les épargnes de matière (25) étant remplies d'air.

6. Arrangement de circuit (15) selon l'une des revendications précédentes, l'élément formant cavalier (26) présentant une épaisseur (34) mesurée perpendiculairement à la surface (21) qui est inférieure à une épaisseur (35) du dissipateur thermique (17) dans une zone adjacente à l'élément formant cavalier (26).

7. Arrangement de circuit (15) selon l'une des revendications précédentes, au moins un canal de refroidissement (18) servant à guider un fluide de refroidissement (19) étant produit au niveau du dissipateur thermique (17).

8. Arrangement de circuit (15) selon l'une des revendications précédentes, un matériau de la couche conductrice (28) étant poreux au moins dans la zone de l'élément formant cavalier (26) .

9. Arrangement de circuit (15) selon l'une des revendications précédentes, au moins un composant électronique (11) commutable étant disposé sur la surface (21) du dissipateur thermique (17), lequel est connecté électriquement à l'une des zones de raccordement (22, 23).

10. Véhicule automobile (10) comprenant une source de tension (13) et comprenant au moins un récepteur de courant fort (11), lequel présente un courant de service (14) supérieur à 10 A, **caractérisé en ce que** la source de tension (13) et l'au moins un récepteur de courant fort (11) sont reliés électriquement par le biais d'un arrangement de circuit (15) selon l'une des revendications précédentes.

11. Procédé de fabrication d'un arrangement de circuit (15) comprenant un fusible (16), un arrangement de couches (20), constitué d'une couche isolante (27) en un matériau électriquement isolant disposée sur le dissipateur thermique (17) et d'une couche conductrice (28) en un matériau électriquement conducteur disposée sur un côté de la couche isolante (27) à l'opposé du dissipateur thermique (17), étant généré sur une surface (21) d'un dissipateur thermique (17) au moyen de la projection à gaz froid, un trajet de liaison électrique (24) étant produit entre les zones de raccordement (22, 23) par l'arrangement de couches (20),
**caractérisé en ce que** pour produire le fusible (16), la surface (21) du dissipateur thermique (17) est produite avec deux épargnes de matière (25), de sorte qu'un élément formant cavalier (26) est formé par une partie du dissipateur thermique (17) disposée entre les épargnes de matière (25), et l'arrangement de couches (20) est généré entièrement ou partiellement sur l'élément formant cavalier (26).
